# EUROPEAN PATENT SPECIFICATION

(11) **EP 2 610 597 B1**
(45) Date of publication and mention of the grant of the patent: **18.11.2015**
(21) Application number: 11819738.3
(22) Date of filing: 21.07.2011
(51) Int. Cl.: G01H 11/08, H01L 41/113

(54) **VIBRATION SENSOR**
VIBRATIONSSENSOR
CAPTEUR DE VIBRATION

(30) Priority: 24.08.2010 JP 2010187016
(43) Date of publication of application: 03.07.2013
(73) Proprietor: NEC Corporation, Tokyo 108-8001 (JP)
(72) Inventor: KASAI, Shigeru, Tokyo 108-8001 (JP); SHINODA, Shigeki, Tokyo 108-8001 (JP); SASAKI, Yasuhiro, Tokyo 108-8001 (JP); KASAI, Shigeru, Tokyo 108-8001 (JP)
(74) Representative: Gill, David Alan
(86) International application number: PCT/JP2011/067177
(87) International publication number: WO 2012/026273

(56) References cited:
- WO-A1-96/08701
- JP-A- 1 269 400
- JP-A- 7 123 496
- JP-A- 9 196 682
- JP-A- 11 051 964
- JP-A- 60 138 431
- JP-A- 2000 275 127
- JP-A- 2001 349 900
- JP-A- 2005 274 322
- JP-A- 2006 023 250
- JP-A- 2007 108 187

## Description

### TECHNICAL FIELD

The present invention relates to vibration sensors, and in particular, to a vibration sensor using a piezoelectric element.

### BACKGROUND ART

A vibration sensor is widely used for an electronic device such as a personal computer, an office automation equipment, or the like, an electronic component of which the electronic device is composed, and the like. In recent years, the vibration sensor is beginning to be used in a wide range of fields such as a vibration characteristic evaluation, an abnormal vibration detection, an investigation on earthquake protection, and the like for various industrial equipments, a manufacturing facility, and a large structure such as a building, a bridge, or the like.

The various kinds of vibration sensors have been developed and used in accordance with an object to be measured or a measurement environment taking advantage of each feature. There are some kinds of vibration sensors: a contact-type piezoelectric vibration sensor suitable for detecting the acceleration arising in the object to be measured, an electrodynamic vibration sensor suitable for detecting a velocity, an eddy current vibration sensor or a capacitance vibration sensor suitable for non-contact detection of a displacement, and the like.

Among these sensors, the piezoelectric vibration sensor is easy to realize a wide band and high sensitivity characteristic with a small size. Therefore, by mounting the piezoelectric vibration sensor in a terminal such as a personal computer or the like, it can be expected that the value of the terminal will be increased and additionally, new services cooperating with a network will be created. In recent years, from the above-mentioned reasons, the piezoelectric vibration sensor has been developed for realization of smaller size, high sensitivity characteristics, in a wide band, a high level of mass production technology, and low cost.

One example of a piezoelectric vibration sensor device 101 is described in patent literature 1. Fig. 10 is a structural schematic view of the piezoelectric vibration sensor device 101 described in patent literature 1. A load body 103 is attached to a detection section to which an electrode is fixed through an adhesive layer provided for both surfaces of a piezoelectric body 102. A signal process substrate 104 is fixed to the detection section and housed in a package.

The package is composed of a housing body 105 and a housing cover body 106 which covers an upper part of an opening of the housing body 105. The housing body 105 and the housing cover body 106 are made of a conducting substance. The detection section is housed in a concave portion provided for the housing body 105. A conductive layer 107 is provided for the upper side of the signal process substrate 104 fixed to the detection section. The housing cover body 106 covering the signal process substrate 104 and the conductive layer 107 is structurally integrated with the housing body 105.

The detection section of the piezoelectric vibration sensor device 101 is equivalently double-shielded by the conductive layer 107 provided for the upper side of the signal process substrate 104 and the housing cover body 106 made of conducting material. Therefore, as to the piezoelectric vibration sensor device 101, it is possible to improve an S/N ratio remarkably and to improve noise resistance properties, water-resistance properties, and oil-resistance properties. In the piezoelectric vibration sensor device 101 described in patent literature 1, because it is possible to lower its center of gravity, the impact resistance properties can be improved and a crosstalk can be reduced.

### Patent literature

patent literature 1: Japanese Patent Application Laid-Open No. H06-201451

WO-A-96/08701 discloses an electromechanical transducer with a piezoelectric layer formed on an amplifier circuit.

JP-A-11051964 discloses an acceleration sensor having a circuit board arranged on the side of a sensor section which includes a piezoelectric element.

However, the vibration sensor device 101 described in patent literature 1 has a structure in which the load body 103, the piezoelectric body 102, the signal process substrate 104, and the like are stacked in the same direction, specifically in the height direction (thickness direction) of the vibration sensor device 101. Therefore, since the size of the vibration sensor device 101 becomes larger in the thickness direction, the vibration sensor device 101 described in patent literature 1 has a problem that it cannot be assembled and mounted in a terminal or the like.

The object of the present invention is to provide a vibration sensor which solves the above-mentioned problem.

According to the invention there is provided a vibration sensor comprising: a piezoelectric vibrator comprising a diaphragm and a piezoelectric element firmly fixed to at least one plane surface of the diaphragm; a signal process substrate arranged to perform a predetermined process to an electric charge outputted from the piezoelectric vibrator; wherein the piezoelectric vibrator and the signal process substrate are arranged on the same plane and alongside each other in a planar direction nearly perpendicular to a vibration direction of the piezoelectric vibrator, and wherein the weight of the piezoelectric vibrator and the weight of the signal process substrate are substantially equal to each other.

### EFFECT OF THE INVENTION

According to the vibration sensor by the present invention, it becomes possible to lower its height.

### BRIEF DESCRIPTION OF THE DRAWINGS

Fig. 1 is a top view of the vibration sensor 1 according to the first exemplary embodiment outside the scope of the invention.
Fig. 2 is a top view of the vibration sensor 1 according to the second exemplary embodiment.
Fig. 3 is a sectional view of the vibration sensor 1 according to the second exemplary embodiment.
Fig. 4 is a sectional view of the vibration sensor 1 according to the second exemplary embodiment.
Fig. 5 is a top view of the vibration sensor 1 according to the third exemplary embodiment.
Fig. 6 is a top view of the vibration sensor 1 according to the fourth exemplary embodiment.
Fig. 7 is a top view of the vibration sensor 1 according to the fifth exemplary embodiment.
Fig. 8 shows crosstalk average values when vibration is applied to the vibration sensor 1 in the X direction in the example.
Fig. 9 shows crosstalk average values when vibration is applied to the vibration sensor 1 in the Y direction in the example.

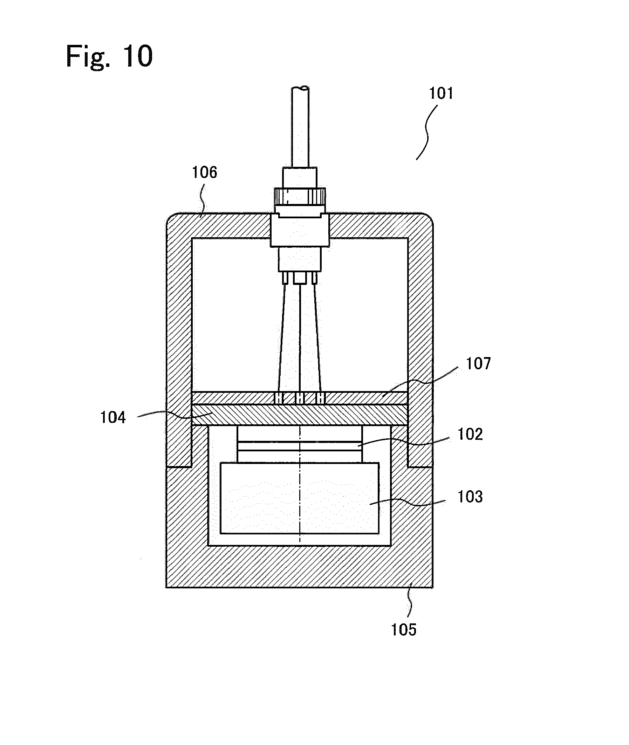

Fig. 10 is a sectional view of a piezoelectric vibration sensor device 101 described in the patent literature 1.

### DESCRIPTION OF EMBODIMENTS

### [Description of the structure]

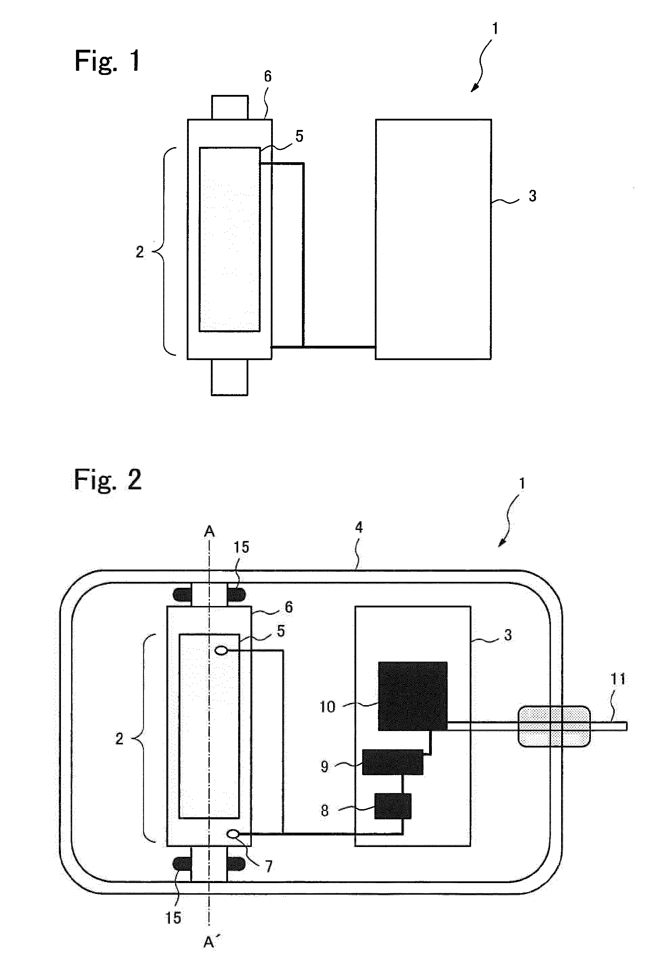

As shown in Fig. 1, a vibration sensor 1 according to the present exemplary embodiment outside the scope of the invention includes a piezoelectric vibrator 2 and a signal process substrate 3.

The piezoelectric vibrator 2 is composed of a piezoelectric element 5 and a diaphragm 6. The piezoelectric element 5 is firmly fixed to at least one of principal surfaces of the diaphragm 6. It is desirable that the principal surface of the piezoelectric element 5 is firmly fixed and connected to the principal surface of the diaphragm 6 oppositely.

The piezoelectric vibrator 2 and the signal process substrate 3 are arranged in the vibration direction of the piezoelectric vibrator 2, that is, in the planar direction nearly perpendicular to the thickness direction of the piezoelectric vibrator 2. That is to say, the piezoelectric vibrator 2 and the signal process substrate 3 are arranged alongside on the same plane.

### [Description of the function and the effect]

Since in the vibration sensor 1 the piezoelectric vibrator 2 and the signal process substrate 3 are arranged alongside in the planar direction nearly perpendicular to the direction of the vibration detection, it is possible to lower the height of the vibration sensor 1. That is to say, compared with the structure disclosed in the patent literature 1 in which the piezoelectric vibrator 2 and the signal process substrate 3 are stacked in the thickness direction, that is, the direction of the vibration detection, it is possible to lower the height.

In case of the structure disclosed in the patent literature 1 in which the signal process substrate 3 is stacked in the vibration direction of the piezoelectric element 5, the variation in the position of the center of gravity arises when the device is assembled. In the vibration sensor 1, the piezoelectric vibrator 2 and the signal process substrate 3 are arranged alongside in the planar direction nearly perpendicular to the vibration direction of the piezoelectric element 5. Therefore, since the arrangement relation between the piezoelectric vibrator 2 and the signal process substrate 3 can be easily adjusted, the variation in the position of the center of gravity in the vibration sensor 1 can be suppressed when assembling it. An influence of a crosstalk can be suppressed which indicates the ratio of a cross-axis sensitivity to a main axis sensitivity In other words, because the ratio of the direction not involving the vibration direction to the vibration direction of the piezoelectric vibrator 2 can be suppressed, it is possible to reduce the variation in the piezoelectric vibrator 2..

### [Second exemplary embodiment]

Next, a second exemplary embodiment will be described by using the drawing.

### [Description of the structure]

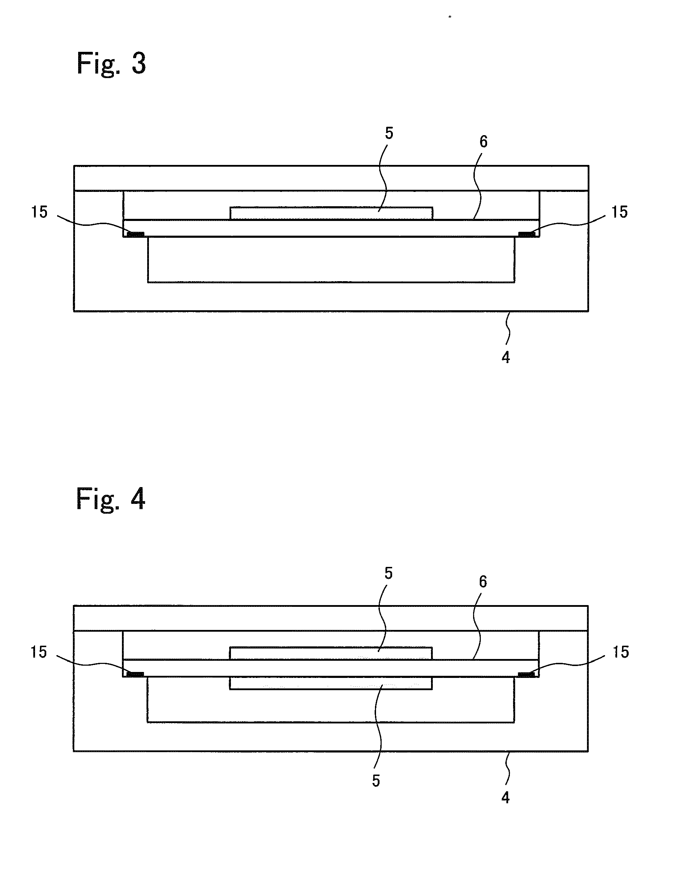

Fig. 2 is a top view of the vibration sensor 1 according to the present exemplary embodiment. Fig. 3 is a sectional view taken along the line A - A' shown in Fig. 2.

As shown in Fig. 2, the vibration sensor 1 according to the present exemplary embodiment includes the piezoelectric vibrator 2, the signal process substrate 3, and a housing 4.

The piezoelectric vibrator 2 is composed of the piezoelectric element 5 and the diaphragm 6. The piezoelectric element 5 has a planar shape and is made of PZT (Lead Zirconate Titanate). Similarly, the diaphragm 6 has a planar shape and is made of a metal such as copper *phosphate* or the like. The shape and the material of the piezoelectric element 5 and the diaphragm 6 are not limited to the above-mentioned shape and material if the same effect that is the same as the above effect can be realized.

As showing in a sectional view in Fig. 3, the housing 4 is nearly box-shaped including a space therein. The piezoelectric vibrator 2 is placed in the housing 4. The both ends of the piezoelectric vibrator 2 are bonded and fixed to the housing 4 by an electrically-conductive adhesive 15 or the like. Since the both ends of the piezoelectric vibrator 2 are fixed to the housing 4, a both-sides supported beam structure is configured in which the housing 4 is used as a support body. The principal surface of the piezoelectric vibrator 2 is provided for the position parallel to the principal surface of the housing 4. It is preferable that the adhesive 15 for fixing the piezoelectric vibrator 2 to the housing 4 should be made of a thermosetting resin whose thickness is equal to or less than 5 µm.

In the present exemplary embodiment, as shown in Fig. 3, the piezoelectric element 5 is firmly fixed to one of the surfaces of the diaphragm 6 facing the housing 4 by the adhesive 15 or the like. As shown in Fig. 2, the electrode 7 is disposed at two positions at least. One is disposed on the diaphragm 6 and the other is disposed on a surface of the piezoelectric element 5, that is, on the surface opposite to the surface to which the diaphragm 6 is fixed. The respective electrodes 7 are electrically connected to the signal process substrate 3 by a wiring or the like.

The structure of the present exemplary embodiment is not limited to the above-mentioned structure. As shown in Fig. 4, the piezoelectric element 5 may be disposed on the both surfaces of the diaphragm 6. In the case of the above-mentioned structure, similarly, the electrode 7 is disposed at two positions at least. One is disposed on the diaphragm 6 and the other is disposed on the surface of the piezoelectric element 5, that is, on the surface opposite to the surface to which the diaphragm 6 is fixed. If the piezoelectric elements 5 are disposed on both surfaces of the diaphragm 6, respectively, the electrode 7 may be disposed on each of the piezoelectric elements 5. The electrode 7 is electrically connected to the signal process substrate 3 by a wiring or the like.

As shown in Fig. 2, the signal process substrate 3 includes at least an electric charge voltage conversion processing unit 8, a filter processing unit 9, and a signal amplification processing unit 10 such as an operational amplifier or the like. The electric charge voltage conversion processing unit 8 has a function to convert the inputted electric charge into a voltage signal with a low impedance. The filter processing unit 9 has a function to set an intended sensor measurement frequency band by extracting a signal in the intended frequency band from the inputted signal. The signal amplification processing unit 10 has a function to amplify the inputted signal. The signal process substrate 3 is connected to an external measuring device, a diagnostic device, or the like through a cable 11.

The piezoelectric vibrator 2 and the signal process substrate 3 are arranged alongside to the housing 4 on the same plane. That is to say, the piezoelectric vibrator 2 and the signal process substrate 3 are arranged alongside in the planar direction nearly perpendicular to the vibration direction of the piezoelectric vibrator 2.

### [Description of the function]

Next, the function in the present exemplary embodiment will be described.

If an external force such as a vibration or the like is applied to the housing 4 and the piezoelectric vibrator 2 in the vibration sensor 1 in the detection direction of the vertical direction, the piezoelectric element 5 converts vibration energy applied by the external force into electrical energy by the piezoelectric effect and outputs an electric charge. Since the piezoelectric element 5 is not alone but is firmly fixed to the diaphragm 6, the piezoelectric element 5 has a shape easily bent by the external force and can output more electric charges. As shown in Fig. 4, if the piezoelectric elements 5 are firmly fixed to the both surfaces of the diaphragm 6, it can output much more electric charges.

The frequency of the acceleration that the vibration sensor 1 can detect is determined by the self-resonant frequency of the vibration sensor 1. The higher the rigidity of the vibration sensor 1 is, the higher self-resonant frequency becomes. Therefore, since the piezoelectric vibrator 2 has the both-sides supported beam structure in which the both ends thereof are bonded and fixed to the housing 4, compared with a commonly-used one side supported beam structure, the rigidity becomes higher and it is possible to realize the high self-resonant frequency. Therefore, in the piezoelectric vibrator 2 having the both-sides supported beam structure, the self-resonant frequency can be made higher and the frequency bandwidth for detection can be made wider.

The electric charge outputted from the piezoelectric element 5 is inputted to the signal process substrate 3. In the inside of the signal process substrate 3, first, the inputted electric charge is inputted into the electric charge voltage conversion processing unit 8. The electric charge voltage conversion processing unit 8 converts the electric charge inputted from the piezoelectric element 5 into the voltage signal with a low impedance and outputs it to the filter processing unit 9. The filter processing unit 9 extracts the voltage signal inputted from the electric charge voltage conversion processing unit 8 in the intended frequency band and outputs it to the signal amplification processing unit 10. The signal amplification processing unit 10 amplifies the voltage signal inputted from the filter processing unit 9.

The signal process substrate 3 outputs the voltage signal outputted from the signal amplification processing unit 10 to an external measuring device, a diagnostic device, or the like through the cable 11.

### [Description of the effect]

Next, the effect of the present exemplary embodiment will be described.

In the vibration sensor 1 according to the present exemplary embodiment, the height of the vibration sensor 1 can be lowered by arranging the piezoelectric vibrator 2 and the signal process substrate 3 alongside in the planar direction nearly perpendicular to the direction of the vibration detection. That is to say, the height of the vibration sensor 1 can be lowered in comparison with the structure described in the patent literature 1 in which the piezoelectric vibrator 2 and the signal process substrate 3 are stacked in the thickness direction, that is, the vibration detection direction.

In the vibration sensor 1 according to the present exemplary embodiment, the piezoelectric vibrator 2 and the signal process substrate 3 are arranged alongside in the planar direction nearly perpendicular to the vibration direction of the piezoelectric element 5. Therefore, since the arrangement relation between the piezoelectric vibrator 2 and the signal process substrate 3 can be easily adjusted, the variation in the position of the center of gravity in the vibration sensor 1 can be suppressed when assembling it. As a result, an influence of the crosstalk can be suppressed which indicates the ratio of the cross-axis sensitivity to the main axis sensitivity. In other words, because the ratio of the direction not involving the vibration direction to the vibration direction of the piezoelectric vibrator 2 can be suppressed, it is possible to reduce the variation in the piezoelectric vibrator 2.

In the vibration sensor 1 according to the present exemplary embodiment, by making the weight of the piezoelectric vibrator 2 and the weight of the signal process substrate 3 substantially equal to each other, the position of the center of gravity in the vibration sensor 1 can be made stable and the variation in the piezoelectric vibrator 2 can be further suppressed. Further, if one of the piezoelectric vibrator 2 and the signal process substrate 3 has a trouble and its replacement is required, one of them can be quickly replaced. Therefore, the manufacturability and the maintainability are improved.

In the vibration sensor 1 according to the present exemplary embodiment, by using the adhesive 15 made of a thermosetting resin whose thickness is equal to or less than 5 µm, the electrical characteristic can be improved, the selection range of the adhesive 15 to be applied can be widened, and the vibration sensor 1 with high quality and low cost can be realized.

### [Third exemplary embodiment]

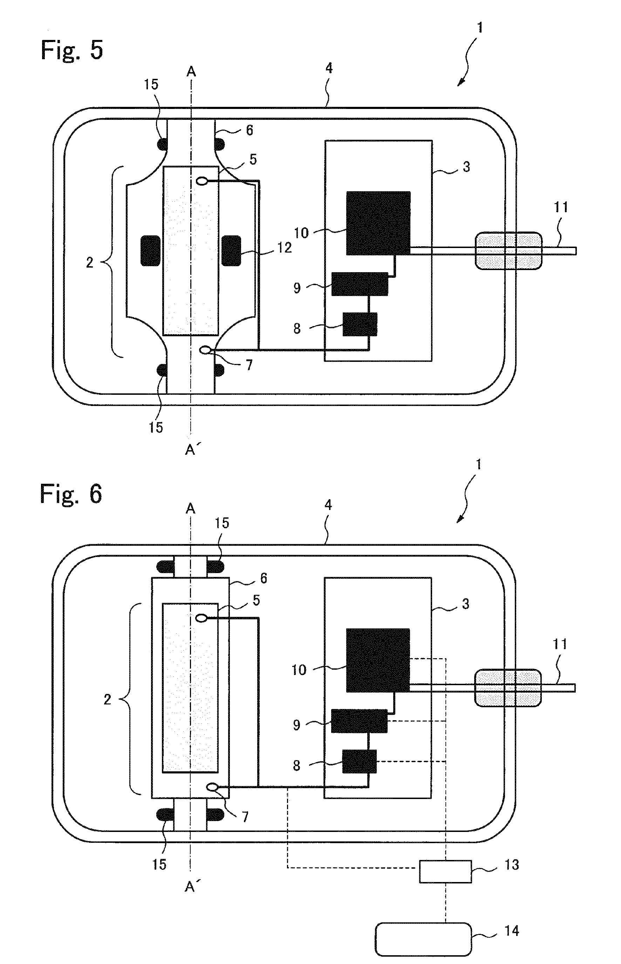

Next, a third exemplary embodiment will be described. Fig. 5 is a top view of a vibration sensor of the exemplary embodiment.

### [Description of the structure]

The different point of the present exemplary embodiment from the second exemplary embodiment is that a weight 12 is arranged on the diaphragm 6 of the piezoelectric vibrator 2 as shown in Fig. 5. Except for the above-mentioned point, the structure and the relation of the connection are the same as those of the first exemplary embodiment. That is to say, the vibration sensor 1 of the third exemplary embodiment is provided with the piezoelectric vibrator 2, the signal process substrate 3, and the housing 4.

In the vibration sensor 1 described in Fig. 5, the weight 12 is arranged on the same surface of the diaphragm 6 as that on which the piezoelectric element 5 is arranged. The weight 12 may be arranged on the opposite surface of the diaphragm 6 to that on which the piezoelectric element 5 is arranged. A plurality of weights 12 are disposed and arranged symmetrically to the piezoelectric element 5, respectively.

### [Description of the function and effect]

In the vibration sensor 1 according to the third exemplary embodiment, by arranging the weights 12 symmetrically to the piezoelectric element 5, the vibration of the piezoelectric vibrator 2 can be amplified and the output electric charge can be increased.

Since the weights 12 are arranged symmetrically to the piezoelectric element 5 in the piezoelectric vibrator 2, the vibration mode of the piezoelectric vibrator 2 itself can be made stable. As a result, the mass balance between the piezoelectric vibrator 2 and the signal process substrate 3 can be adjusted and the stable vibration can be realized.

### [Fourth exemplary embodiment]

Next, a fourth exemplary embodiment will be described. Fig. 6 is a top view of a vibration sensor of the present exemplary embodiment.

### [Description of the structure]

The different point of the structure of the fourth exemplary embodiment compared with that of the second exemplary embodiment is that .a switch 13 is disposed between the signal process substrate 3 and an external device 14 as shown in Fig. 6. Except for the above-mentioned point, the structure and the relation of connection are the same as those of the first exemplary embodiment. That is to say, the vibration sensor 1 according to the second exemplary embodiment is provided with the piezoelectric vibrator 2, the signal process substrate 3, and the housing 4.

In the vibration sensor 1 according to the present exemplary embodiment, the switch 13 is disposed between the signal process substrate 3 and the external device 14. If the vibration is applied to the piezoelectric vibrator 2 and the outputted electric charge becomes greater than or equal to a predetermined value, the switch 13 operates and starts to supply electric power to the electronic components such as the electric charge voltage conversion processing unit 8, the filter processing unit 9, the signal amplification processing unit 10, and the like on the signal process substrate 3.

### [Description of the function and effect]

In the vibration sensor 1 according to the present exemplary embodiment, the vibration applied to the piezoelectric vibrator 2 is converted into electrical energy and if the electric charge outputted from the piezoelectric vibrator 2 becomes greater than or equal to a predetermined value, the switch operates. When the switch operates, the external device 14 starts to supply electric power to the electric charge voltage conversion processing unit 8, the filter processing unit 9, and the signal amplification processing unit 10 on the signal process substrate 3. If the electric power is supplied from the external device 14, the electric charge voltage conversion processing unit 8, the filter processing unit 9, and the signal amplification processing unit 10 start to perform a signal process for the inputted electric charge.

That is to say, since the switch 13 does not operate unless the vibration exceeding a certain predetermined amount arises, the electronic component does not operate by small vibrations around it such as environmental vibration or the like. Therefore, the driving power consumption of the vibration sensor 1 can be suppressed.

### [Fifth exemplary embodiment]

Next, a fifth exemplary embodiment will be described.

### [Description of the structure]

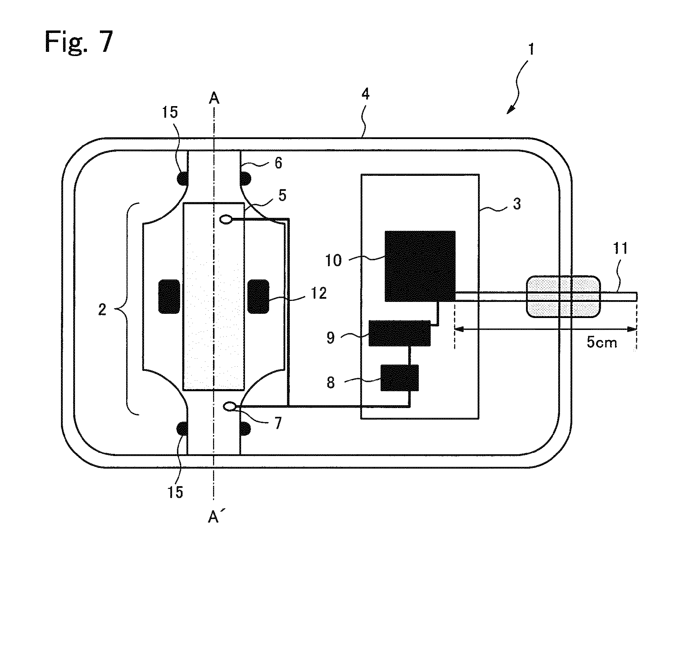

The different point of the present exemplary embodiment from the second exemplary embodiment is that if a device to be measured is a storage device mounted in a personal computer or the like, the length of the cable 11 connected to the signal process substrate 3 is made equal to or less than 5 cm, as shown in Fig. 7.. Except for the above-mentioned point, the structure and the relation of connection are the same as those of the first exemplary embodiment. That is to say, the vibration sensor 1 of the second exemplary embodiment is provided with the piezoelectric vibrator 2, the signal process substrate 3, and the housing 4.

### [Description of the function and effect]

In the vibration sensor 1 according to the present exemplary embodiment, if a device to be measured is a storage device mounted in a personal computer or the like, the length of the cable 11 connected to the signal process substrate 3 is made equal to or less than 5 cm. By this means, because of being insusceptible to a internal noise of a device such as a personal computer or the like, a high signal to noise ratio can be realized.

### [Example]

An example will be described. Hereinafter, dimensions and materials of each component will be described below. The vibration sensor 1 has dimensions of about 8.5 mm in length, about 8.5 mm in width, and about 3 mm in thickness. The piezoelectric vibrator 2 has dimensions of about 5 mm in length, about 3 mm in width, and 0.62 mm in thickness. The piezoelectric element 5 has dimensions of about 4.5 mm in length, about 2.5 mm in width, and 0.5 mm in thickness. The signal process substrate 3 has dimensions of about 5 mm in length, about 3.2 mm in width, and 1 mm in thickness. The material of the diaphragm 6 is phosphor bronze and the material of the piezoelectric element 5 is PZT (lead zirconate titanate). The dimensions and the materials are not limited to these mentioned above.

Next, the crosstalk characteristic has been evaluated which indicates a ratio of the cross-axis sensitivity to the main axis sensitivity of the vibration sensor 1 according to the present example. In the evaluation of the crosstalk characteristics, the output sensitivity has been investigated on the condition that the vibration sensor 1 is arranged on a shaker and the direction of the cross-axis detection in the vibration sensor 1 is set corresponding to the vibration direction of the shaker.

The direction in thickness of the piezoelectric vibrator 2 is set for a main axis sensitivity direction. Cross-axis sensitivity directions are set in a longer direction (X direction) of the piezoelectric vibrator 2 and in a shorter direction (Y direction) of the piezoelectric element 5. In the above-mentioned case, when the vibration is applied to the vibration sensor 1, the crosstalk has been measured.

In this example, the piezoelectric vibrator 2 and the signal process substrate 3 are arranged alongside to the housing 4 on the same plane. That is to say, the piezoelectric vibrator 2 and the signal process substrate 3 are arranged alongside in the planar direction nearly perpendicular to the vibration direction that is the main axis sensitivity direction of the piezoelectric vibrator 2. In other words, the piezoelectric vibrator 2 and the signal process substrate 3 are arranged alongside in the same plane.

On the other hand, as a comparative example, the crosstalk characteristics of the structure described in the patent literature 1, in which the piezoelectric vibrator 2 and the signal process substrate 3 are stacked and arranged in the vibration direction of the main axis sensitivity direction, has also been evaluated.

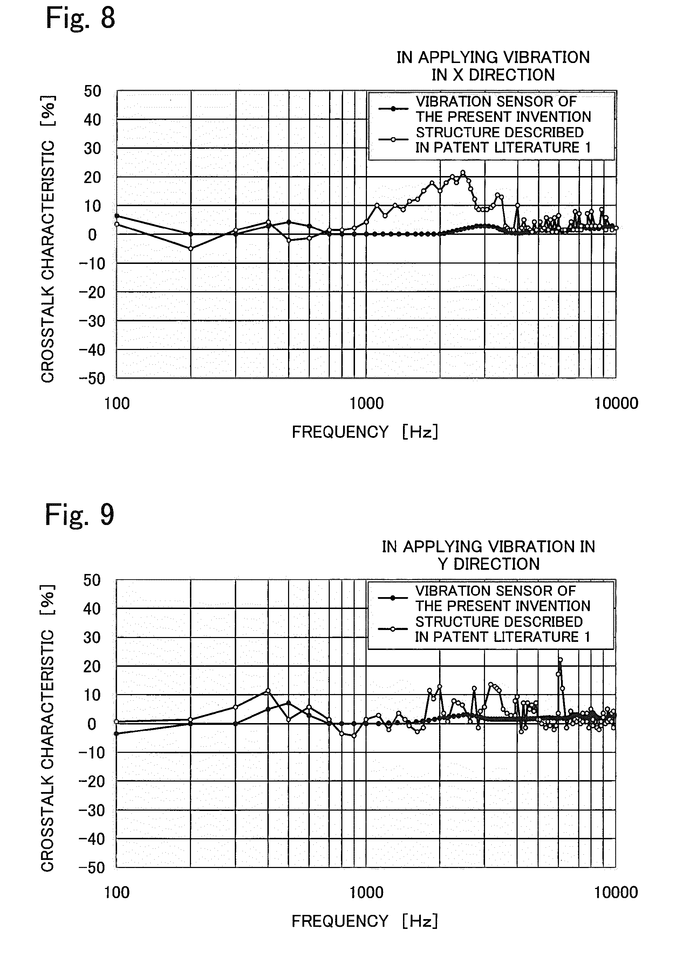

Ten samples have been evaluated for each structure. The experimental results shown in Fig. 8 represent crosstalk characteristics average values for 5 samples of in applying the vibration in the X direction of the vibration sensor 1. Further, the experimental results shown in Fig. 9 represent crosstalk characteristics average values for 5 samples of in applying the vibration in the Y direction of the vibration sensor. It is understood that in the frequency band from 100 Hz to 10 KHz, the crosstalk characteristics in the structure according to this example is greatly improved in comparison with the comparative example.

From the above-mentioned results, it is understood that the height of the vibration sensor 1 can be lowered by arranging the piezoelectric vibrator 2 and the signal process substrate 3 alongside in the planar direction of the housing 4 that is nearly perpendicular to the vibration detection direction, the variation of the crosstalk characteristics can be made smaller, and the crosstalk characteristics are remarkably improved.

This application is based upon and claims the benefit of priority from Japanese Patent Application No. 2010-187016, filed on August 24, 2010.

### DESCRIPTION OF THE CODES

- 1: vibration sensor
- 2: piezoelectric vibrator
- 3: signal process substrate
- 4: housing
- 5: piezoelectric element
- 6: diaphragm
- 7: electrode
- 8: electric charge voltage conversion processing unit
- 9: filter processing unit
- 10: signal amplification processing unit
- 11: cable
- 12: weight
- 13: switch
- 14: external device
- 15: adhesive
- 101: piezoelectric vibration sensor device
- 102: piezoelectric body
- 103: load body
- 104: signal process substrate
- 105: housing body
- 106: housing cover body
- 107: conductive layer

## Claims

1. A vibration sensor (1) comprising:
a piezoelectric vibrator (2) comprising a diaphragm (6) and a piezoelectric element (5) firmly fixed to at least one plane surface of the diaphragm (6);
a signal process substrate (3) arranged to perform a predetermined process to an electric charge outputted from the piezoelectric vibrator (2);
wherein the piezoelectric vibrator (2) and the signal process substrate (3) are arranged on the same plane and alongside each other in a planar direction nearly perpendicular to a vibration direction of the piezoelectric vibrator (2), and
**characterized in that**
the weight of the piezoelectric vibrator (2) and the weight of the signal process substrate (3) are substantially equal to each other.

2. The vibration sensor according to Claim 1,
wherein the vibration sensor comprises a housing (4) in which the piezoelectric vibrator (2) and the signal process substrate (3) are placed, and
the both ends of the piezoelectric vibrator (2) are fixed to the housing (4).

3. The vibration sensor according to Claim 1 or 2, wherein the signal process substrate (3) comprises
an electric charge voltage conversion processing unit (8) arranged to convert an inputted electric charge into a voltage signal,
a filter processing unit (9) arranged to extract a signal in an intended frequency band among the inputted voltage signals, and
a signal amplification processing unit (10) arranged to amplify the voltage signal outputted from the filter processing unit (9).

4. The vibration sensor according to any one of Claims 1, 2 or 3, further comprising electrodes (7) disposed on the diaphragm (6) and the piezoelectric element (5), wherein
the piezoelectric vibrator (2) is electrically connected to the signal process substrate through the electrode.

5. The vibration sensor according to any one of Claims 1, 2, 3 or 4, wherein
a weight (12) is arranged on the diaphragm (6).

6. The vibration sensor according to Claim 5,
wherein at least two weights are disposed on the diaphragm (6) and arranged symmetrically to the piezoelectric element (5).

7. The vibration sensor according to any one of Claims 2, 3, 4, 5 or 6, wherein
the piezoelectric vibrator (2) is fixed to the housing (4) by an adhesive and the thickness of the adhesive is equal to or less than 5 µm.

8. The vibration sensor according to any one of Claims 1, 2, 3, 4, 5, 6 or 7, wherein
the signal process substrate (3) comprises a switch arranged to start to supply power to the signal process substrate (3) if an electric charge inputted from the piezoelectric vibrator (2) is greater than or equal to a predetermined value.

9. The vibration sensor according to any one of Claims 1, 2, 3, 4, 5, 6, 7 and 8, wherein
the signal process substrate (3) is electrically connected to an external device through a cable (11) and the length of the cable (11) is equal to or less than 5 cm.

## Patentansprüche

1. Vibrationssensor (1), der Folgendes umfasst:
einen piezoelektrischen Vibrator (2), der eine Membran (6) und ein piezoelektrisches Element (5) umfasst, das fest an wenigstens einer ebenen Fläche der Membran (6) befestigt ist;
ein Signalverarbeitungssubstrat (3) zum Ausführen einer vorbestimmten Verarbeitung an einer von dem piezoelektrischen Vibrator (2) ausgegebenen elektrischen Ladung;
wobei der piezoelektrische Vibrator (2) und das Signalverarbeitungssubstrat (3) auf derselben Ebene und nebeneinander in einer planaren Richtung nahezu lotrecht zu einer Vibrationsrichtung des piezoelektrischen Vibrators (2) angeordnet sind, und
**dadurch gekennzeichnet, dass** das Gewicht des piezoelektrischen Vibrators (2) und das Gewicht des Signalverarbeitungssubstrats (3) im Wesentlichen gleich sind.

2. Vibrationssensor nach Anspruch 1, wobei
der Vibrationssensor ein Gehäuse (4) umfasst, in dem der piezoelektrische Vibrator (2) und das Signalverarbeitungssubstrat (3) untergebracht sind, und
die beiden Enden des piezoelektrischen Vibrators (2) an dem Gehäuse (4) befestigt sind.

3. Vibrationssensor nach Anspruch 1 oder 2, wobei das Signalverarbeitungssubstrat (3) Folgendes umfasst:
eine Spannungskonversionsverarbeitungseinheit (8) für elektrische Ladung zum Konvertieren einer eingegebenen elektrischen Ladung in ein Spannungssignal,
eine Filterverarbeitungseinheit (9) zum Extrahieren eines Signals in einem beabsichtigten Frequenzband unter den eingegebenen Spannungssignalen, und
eine Signalverstärkungsverarbeitungseinheit (10) zum Verstärken des von der Filterverarbeitungseinheit (9) ausgegebenen Spannungssignals.

4. Vibrationssensor nach einem der Ansprüche 1, 2 oder 3, der ferner Elektroden (7) umfasst, die auf der Membran (6) und dem piezoelektrischen Element (5) angeordnet sind, wobei
der piezoelektrische Vibrator (2) durch die Elektrode elektrisch mit dem Signalverarbeitungssubstrat verbunden ist.

5. Vibrationssensor nach einem der Ansprüche 1, 2, 3 oder 4, wobei ein Gewicht (12) auf der Membran (6) angeordnet ist.

6. Vibrationssensor nach Anspruch 5, wobei wenigstens zwei Gewichte auf der Membran (6) symmetrisch zu dem piezoelektrischen Element (5) angeordnet sind.

7. Vibrationssensor nach einem der Ansprüche 2, 3, 4, 5 oder 6, wobei
der piezoelektrische Vibrator (2) mit einem Klebstoff an dem Gehäuse (4) befestigt ist und die Dicke des Klebstoffs gleich oder weniger als 5 µm ist.

8. Vibrationssensor nach einem der Ansprüche 1, 2, 3, 4, 5, 6 oder 7, wobei
das Signalverarbeitungssubstrat (3) einen Schalter zum Starten der Zufuhr von Strom zu dem Signalverarbeitungssubstrat (3) umfasst, wenn eine von dem piezoelektrischen Vibrator (2) eingegebene elektrische Ladung gleich oder größer als ein vorbestimmter Wert ist.

9. Vibrationssensor nach einem der Ansprüche 1, 2, 3, 4, 5, 6, 7 und 8, wobei
das Signalverarbeitungssubstrat (3) elektrisch mit einem externen Gerät durch ein Kabel (11) verbunden ist und die Länge des Kabels (11) gleich oder kleiner als 5 cm ist.

## Revendications

1. Un capteur de vibrations (1) comprenant :
un vibrateur piézoélectrique (2) comprenant un diaphragme (6) et un élément piézoélectrique (5) fermement fixé à au moins une surface plane du diaphragme (6),
un substrat de traitement de signal (3) agencé de façon à exécuter un processus prédéterminé sur une charge électrique produite en sortie à partir du vibrateur piézoélectrique (2),
où le vibrateur piézoélectrique (2) et le substrat de traitement de signal (3) sont agencés sur le même plan et l'un à côté de l'autre dans une direction planaire presque perpendiculaire à une direction de vibration du vibrateur piézoélectrique (2), et
**caractérisé en ce que** :
le poids du vibrateur piézoélectrique (2) et le poids du substrat de traitement de signal (3) sont sensiblement égaux l'un à l'autre.

2. Le capteur de vibrations selon la Revendication 1, où le capteur de vibrations comprend un logement (4) dans lequel le vibrateur piézoélectrique (2) et le substrat de traitement de signal (3) sont placés, et
les deux extrémités du vibrateur piézoélectrique (2) sont fixées au logement (4).

3. Le capteur de vibrations selon la Revendication 1 ou 2, où le substrat de traitement de signal (3) comprend
une unité de traitement de conversion de tension de charge électrique (8) agencée de façon à convertir une charge électrique produite en entrée en un signal de tension,
une unité de traitement de filtre (9) agencée de façon à extraire un signal dans une bande de fréquences projetée parmi les signaux de tension produits en entrée, et
une unité de traitement d'amplification de signal (10) agencée de façon à amplifier le signal de tension produit en sortie à partir de l'unité de traitement de filtre (9).

4. Le capteur de vibrations selon l'une quelconque des Revendications 1, 2 ou 3, comprenant en outre des électrodes (7) disposées sur le diaphragme (6) et l'élément piézoélectrique (5), où
le vibrateur piézoélectrique (2) est électriquement raccordé au substrat de traitement de signal par l'intermédiaire de l'électrode.

5. Le capteur de vibrations selon l'une quelconque des Revendications 1, 2, 3 ou 4, où
un poids (12) est agencé sur le diaphragme (6).

6. Le capteur de vibrations selon la Revendication 5, où au moins deux poids sont disposés sur le diaphragme (6) et agencés symétriquement par rapport à l'élément piézoélectrique (5).

7. Le capteur de vibrations selon l'une quelconque des Revendications 2, 3, 4, 5 ou 6, où
le vibrateur piézoélectrique (2) est fixé au logement (4) par un adhésif et l'épaisseur de l'adhésif est égale ou inférieure à 5 µm.

8. Le capteur de vibrations selon l'une quelconque des Revendications 1, 2, 3, 4, 5, 6 ou 7, où
le substrat de traitement de signal (3) comprend un commutateur agencé de façon à lancer une alimentation en énergie vers le substrat de traitement de signal (3) si une charge électrique envoyée en entrée à partir du vibrateur piézoélectrique (2) est supérieure ou égale à une valeur prédéterminée.

9. Le capteur de vibrations selon l'une quelconque des Revendications 1, 2, 3, 4, 5, 6, 7 et 8, où
le substrat de traitement de signal (3) est électriquement raccordé à un dispositif externe par l'intermédiaire d'un câble (11) et la longueur du câble (11) est égale ou inférieure à 5 cm.
